# EUROPEAN PATENT APPLICATION

(11) **EP 4 606 636 A1**
(43) Date of publication of application: **27.08.2025**
(21) Application number: 25155467.1
(22) Date of filing: 03.02.2025
(51) Int. Cl.: B60L 53/62, B60L 53/66, B60L 53/68, G01R 31/389, G01R 31/50, G01R 35/04, H02J 7/00, H02J 13/00, H04Q 9/00

(54) **ELECTRIC VEHICLE (EV) CHARGING INFRASTRUCTURE QUALITY PREDICTOR**

(30) Priority: 20.02.2024 US 202418581607
(71) Applicant: Siemens Industry, Inc., Alpharetta, GA 30005 (US)
(72) Inventor: FELDMAN, Daniel, New York, 10022 (US); MALACARA, Hector, Alpharetta, 30004 (US)
(74) Representative: Isarpatent

(57) **Abstract**

A predictor of a quality of an electrical installation of electrical vehicle (EV) charging infrastructure is provided. The predictor comprises a monitoring system including software instructions of a central monitoring software to identify whether an electrical circuit is about to fail by connecting to a smart meter measuring the electrical circuit (voltage, current, temp, etc.), as well as a smart EV charger with an internal meter connected to the same electrical circuit. The monitoring system is configured to use the smart meter to measure grid characteristics at a central place with metering information in the smart EV charger behind the central place to estimate the quality of the electrical installation.

## Description

### BACKGROUND

### 1. Field

Aspects of the present invention generally relate to a predictor of a quality of an electrical installation of electrical vehicle (EV) charging infrastructure.

### 2. Description of the Related Art

The increasing number of electric vehicles (EVs) in the near future will require control systems endowed with adequate algorithms able to manage their recharging process and avoiding massive investment in reinforcement of low voltage distribution network infrastructure. The deployment of EVs as an alternative to internal combustion engines will pose new challenges for electric power systems, grid operators, electricity suppliers and consumers. The impacts of the increasing penetration of EVs will be felt at the level of the distribution grid, as the lack of infrastructure capacity may hinder the increasing number of EVs from being simultaneously charged.

Electrical installation powering EV chargers can deteriorate because of the elements, incorrect usage, accident or human damage. Issues in the installation can bring up safety concerns, such as fires, or can just stop working, preventing EV charger utilization.

Up till now users have relied on EV charger safety errors (ground-fault circuit interrupter (GFCI), over temperature, etc., which will tend to happen after the electrical installation is unusable.

Based on network data monitored across the United States this year, the most common reasons for failed EV charging sessions are problems with: station connectivity: 55 percent, internal station faults or errors: 38 percent, charging connector or cable: 4 percent, credit-card reader: 1 percent and display screen: 1 percent.

Therefore, a system is then needed a predictor of a quality of an electrical installation of electrical vehicle (EV) charging infrastructure.

### SUMMARY

Briefly described, aspects of the present invention relate to a predictor of a quality of an electrical installation of electrical vehicle (EV) charging infrastructure. This invention consists of a monitoring system that uses a smart meter that measures the grid characteristics at a central place with the metering information in each EV charger behind this central place to estimate the quality of the electrical installation. In order to identify whether a circuit is about to fail, the following method is employed, by a central monitoring software, that can connect to a smart meter measuring a circuit (voltage, current, temp, etc.), as well as the smart EV chargers (with internal meters) connected to the same circuit. Whenever a smart EV charger is charging, the monitoring system will compare the voltage between the smart meter and the smart EV charger. Predicting a failure is going to happen based on a deteriorated resistance in an electrical circuit. An electrical circuit that presents a higher resistance than expected can cause overheating and damage.

In accordance with one illustrative embodiment of the present invention, a predictor of a quality of an electrical installation of electrical vehicle (EV) charging infrastructure is provided. The predictor comprises a monitoring system including software instructions of a central monitoring software to identify whether an electrical circuit is about to fail by connecting to a smart meter measuring the electrical circuit (voltage, current, temp, etc.), as well as a smart EV charger with an internal meter connected to the same electrical circuit. The monitoring system is configured to use the smart meter to measure grid characteristics at a central place with metering information in the smart EV charger behind the central place to estimate the quality of the electrical installation.

In accordance with one illustrative embodiment of the present invention, a method of predicting a quality of an electrical installation of electrical vehicle (EV) charging infrastructure is provided. The method provides a monitoring system including software instructions of a central monitoring software to identify whether an electrical circuit is about to fail by connecting to a smart meter measuring the electrical circuit (voltage, current, temp, etc.), as well as a smart EV charger with an internal meter connected to the same electrical circuit. The monitoring system is configured to use the smart meter to measure grid characteristics at a central place with metering information in the smart EV charger behind the central place to estimate the quality of the electrical installation.

The above described features and advantages, as well as others, will become more readily apparent to those of ordinary skill in the art by reference to the following detailed description and accompanying drawings. While it would be desirable to provide one or more of these or other advantageous features, the teachings disclosed herein extend to those embodiments which fall within the scope of the appended claims, regardless of whether they accomplish one or more of the above-mentioned advantages.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects.
FIG. 1 illustrates a predictor of a quality of an electrical installation of electrical vehicle (EV) charging infrastructure including a monitoring system having software instructions of a central monitoring software in accordance with an embodiment of the present invention.
FIG. 2 illustrates a detailed predictor of a quality of an electrical installation of electrical vehicle (EV) charging infrastructure in accordance with an embodiment of the present invention.
FIG. 3 illustrates a method of predicting a quality of an electrical installation of electrical vehicle (EV) charging infrastructure in accordance with an embodiment of the present invention.

### DETAILED DESCRIPTION

Various technologies that pertain to systems and methods that provide a predictor of a quality of an electrical installation of electrical vehicle (EV) charging infrastructure are presented. The method uses the voltage meters on the EV charger, the meter behind and/or any secondary meters. The invention improves EV charger utilization. The charging station utilization rate is a key metric providing valuable information about the business. A 20% utilization rate is often used as the baseline, and a rate above this may warrant network expansion. If customers are steadily increasing, an EVSE owner may need to install more electric vehicle charging infrastructure to cut short queue time and maintain steady utilization. Users don't have to rely on EV charger safety errors for predicting a failure. Adequate insulation and communication protocols between different components in the power systems are required to keep the charging process smooth and stress-free. Communication protocol errors in EV chargers can occur due to various reasons, such as incompatible software versions, network connection issues, or even physical damage to the charging cable. These errors can prevent the charger from effectively communicating with the vehicle, resulting in charging failures or slower charging speeds. Identifying and troubleshooting these errors can save you time and frustration while ensuring smooth charging sessions for your EV. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system elements may be performed by multiple elements. Similarly, for instance, an element may be configured to perform functionality that is described as being carried out by multiple elements. The numerous innovative teachings of the present application will be described with reference to exemplary non-limiting embodiments.

To facilitate an understanding of embodiments, principles, and features of the present invention, they are explained hereinafter with reference to implementation in illustrative embodiments. In particular, they are described in the context of a predictor of a quality of an electrical installation of electrical vehicle (EV) charging infrastructure. Embodiments of the present invention, however, are not limited to use in the described devices or methods.

The components and materials described hereinafter as making up the various embodiments are intended to be illustrative and not restrictive. Many suitable components and materials that would perform the same or a similar function as the materials described herein are intended to be embraced within the scope of embodiments of the present invention.

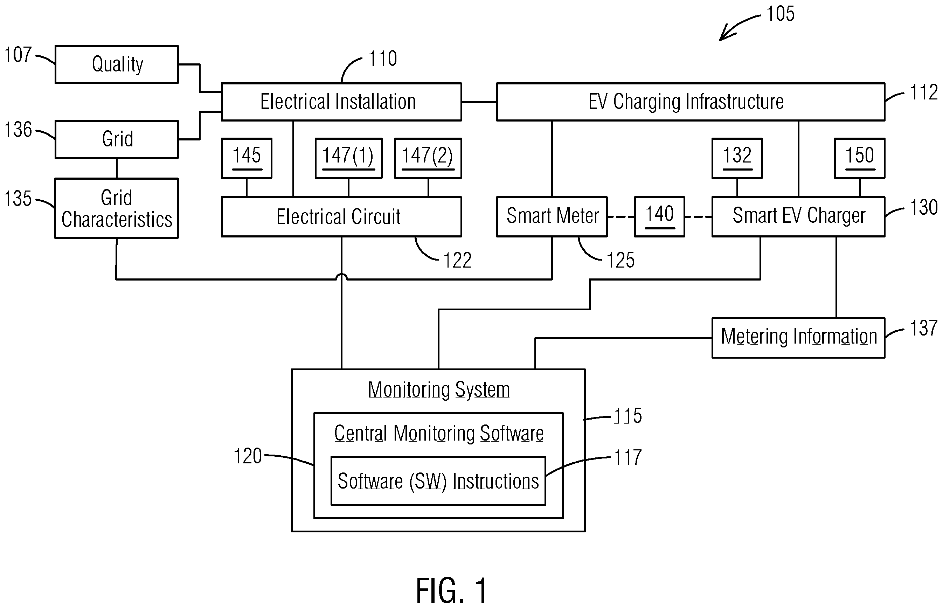

These and other embodiments of the system are provided for providing a fire safe electric vehicle (EV) charging system according to the present disclosure are described below with reference to FIG. 1 herein. The drawing is not necessarily drawn to scale.

Consistent with an embodiment of the present invention, FIG. 1 represents a predictor 105 of a quality 107 of an electrical installation 110 of electrical vehicle (EV) charging infrastructure 112 including a monitoring system 115 having software instructions 117 of a central monitoring software 120 in accordance with an embodiment of the present invention. The predictor 105 comprises the monitoring system 115 including the software instructions 117 of the central monitoring software 120 to identify whether an electrical circuit 122 is about to fail by connecting to a smart meter 125 measuring the electrical circuit 122 (voltage, current, temp, etc.), as well as a smart EV charger 130 with an internal meter 132 connected to the same electrical circuit 122. The monitoring system 115 is configured to use the smart meter 125 to measure grid characteristics 135 of a grid 136 at a central place with metering information 137 in the smart EV charger 130 behind the central place to estimate the quality 107 of the electrical installation 110. Whenever the smart EV charger 130 is charging, the monitoring system 115 will compare a voltage 140 between the smart meter 125 and the smart EV charger 130. Predicting a failure 145 by the monitoring system 115 is going to happen based on a deteriorated resistance 147(1) in the electrical circuit 122. The electrical circuit 122 that presents a higher resistance 147(2) than expected can cause overheating and damage.

The smart meter 125 is a voltage meter and the internal meter 132 of the smart EV charger 130 is a voltage meter. The smart meter 125 is a meter behind the internal meter 132 of the smart EV charger 130. A current 150 flowing through the smart EV charger 130 is known, and therefore a resistance of the electrical circuit 122 between the smart meter 125 and the smart EV charger 130 can be calculated as R = (Vsmart meter - Vev charger)/I such that the resistance can be calculated at different current levels, and at different external ambient temperatures (measured at the smart EV charger 130), as well different charging session durations (as the circuit tends to heat until it reaches stable temperature). This mapping function should take place shortly after the smart EV charger 130 is installed, should be stored, and made visible to an administrator.

The administrator can then enter the wire type used in the software (e.g. AWG 6), which can allow the central monitoring software 120 to estimate the electrical wire length of the electrical circuit 122 for that charger, using a table that maps resistance to the AWG wire (e.g. Electrical Wire Gauges (gsu.edu)). The administrator can then verify whether the length is compatible with the physical circuit on the ground, using information about the location and making sure the correction factors by NEC table 310.15 B2 are met. If the information is incompatible with the location, a site inspection can be put in place. The central monitoring software 120 then can calculate the resistance of the electrical circuit 122 periodically (every few minutes), and compare the effective resistance with the original circuit resistance enabling identification of circuit issues.

The common U.S. wire gauges (called AWG gauges) refer to sizes of copper wire. The resistivity of copper is taken at 20C. This table below uses this value of resistivity, but it is known to vary by a few percent based on purity and process of manufacture.

**TABLE I**

| AWG wire size (solid) | Diameter(inches) | Resistance per 1000 ft (ohms) | Resistance per 1000 m (ohms) |
|---|---|---|---|
| 24 | 0.0201 | 25.67 | 84.2 |
| 22 | 0.0254 | 16.14 | 52.7 |
| 20 | 0.0320 | 10.15 | 33.2 |
| 18 | 0.0403 | 6.385 | 20.9 |
| 16 | 0.0508 | 4.016 | 13.2 |
| 14 | 0.0640 | 2.525 | 8.28 |
| 12 | 0.0808 | 1.588 | 5.21 |
| 10 | 0.1019 | 0.999 | 3.28 |

The quality 107 of the electrical installation 110 directly impacts a reliability of a power supply, fire safety, energy efficiency, and overall functionality of an EV charging system. The quality 107 of the electrical installation 110 determines safety and efficiency. The techniques described herein can be particularly useful for the monitoring system 115 that uses the smart meter 125 that measures grid characteristics (e.g., time-of-use (TOU) electricity tariffs and peak load risk) at a central place with metering information in each smart EV charger 130 behind this central place to estimate the quality 107 of electrical installation. For example, complex power grid characteristics associated with the operation cost and power system safety. In the context of time-of-use (TOU) electricity tariffs, the peak tariff is approximately two or three times its low counterpart. A power grid does three things: it ensures best practice use of energy resources, provides greater power supply capacity, and makes power system operations more economical and reliable. The generating stations are interconnected to reduce the reserve generation capacity, known as a spinning reserve, in each area. A power grid is a network of power lines and associated equipment used to transmit and distribute electricity over a geographic area. Two (or more) inductors that have coupled magnetic flux form a transformer, which is a fundamental component of every electric utility power grid. Electric grids perform three major functions: power generation, transmission, and distribution.

A smart meter provides detailed information on consumption in order to reduce electricity bills and also increase knowledge about the status of the electricity grid, which improves its performance and the quality of service for customers. A smart meter has two main elements: The meter itself, which uses a secure smart data network to automatically send your meter readings to your supplier at least once a month. The in-home digital display, which shows how much energy you're using, when you're using it, and how much it costs. Smart meters can provide data that can be used to plan and develop new charging points. Smart meters can also be used to manage demand for electricity, by automatically charging vehicles during off-peak periods when there is less strain on the grid. Smart meters work by using a secure national communication network (called the DCC) to automatically and wirelessly send your actual energy usage to your supplier.

An electric vehicle supply equipment (EVSE) includes a meter, a switch, a controller and a wireless communication unit. The EVSE is configured to couple to the EV for electrically charging a battery of the EV. The wireless communication unit is configured to communicate with a wireless communication device that is configured to communicate with an EVSE server and a utility server. The EVSE server is configured to communicate with a user communication device. The meter is operable to receive charging information from one or more sources and provide metering information of a first power source and a second power source by measuring values of at least one of charge current and charge voltage and calculate one or more energy usage parameters including charge power usage or charge energy usage from the measured values of charge current and/or charge voltage.

Moreover, EV charger utilization may also be indicative of the quality 107. It is the amount of time an EV is connected to a charger and charging. The utilization rate is defined as the percentage of time the charger was plugged into an EV. If two cars are charging for 1 hour each day the Utilization Factor is (2*365)/(8760) = 8.3%. This is also referred to as Utilization Rate (UR). A recent study determined that only 72.5% of EV charging stations in San Francisco were active and in good working order in March 2022. That means more than one-quarter of stations were out of commission-at best sitting unused and forgotten, at worst frustrating EV drivers who would be sure not to waste their time returning to that spot in the future.

The EV charging infrastructure 112 is defined as structures, machinery, and equipment necessary and integral to support an EV, including battery charging stations, rapid charging stations, and battery exchange stations. The electrical installation 110 is a group of items of electrical equipment that are permanently electrically connected together and can be supplied with electricity from the works of an electricity entity or from a generating source. An item of electrical equipment may be part of more than 1 electrical installation. Selection of cross-sectional-areas of cables or isolated conductors for line conductors is certainly one of the most important tasks of the design process of an electrical installation as this greatly influences the selection of overcurrent protective devices, the voltage drop along these conductors. Commonly encountered electrical installation failures 145 are insecure wiring, wrong wiring sizes, improper wire length, unprotected wiring and connections. The main hazards of working with electricity are: electric shock and burns from contact with live parts, injury from exposure to arcing (when electricity jumps from one circuit to another) fire from faulty electrical equipment or installations. Examples of electrical hazard risks include: electric shock and burns from live wire contact, fires from faulty wiring, overloading circuits, explosions and fires from explosive and flammable substances. EV charging station risks: fire is the number one hazard when it comes to EVSE installations. The most common cause related to the installations themselves is outdated electrical wiring and power supplies within the building or structure where the charger is installed.

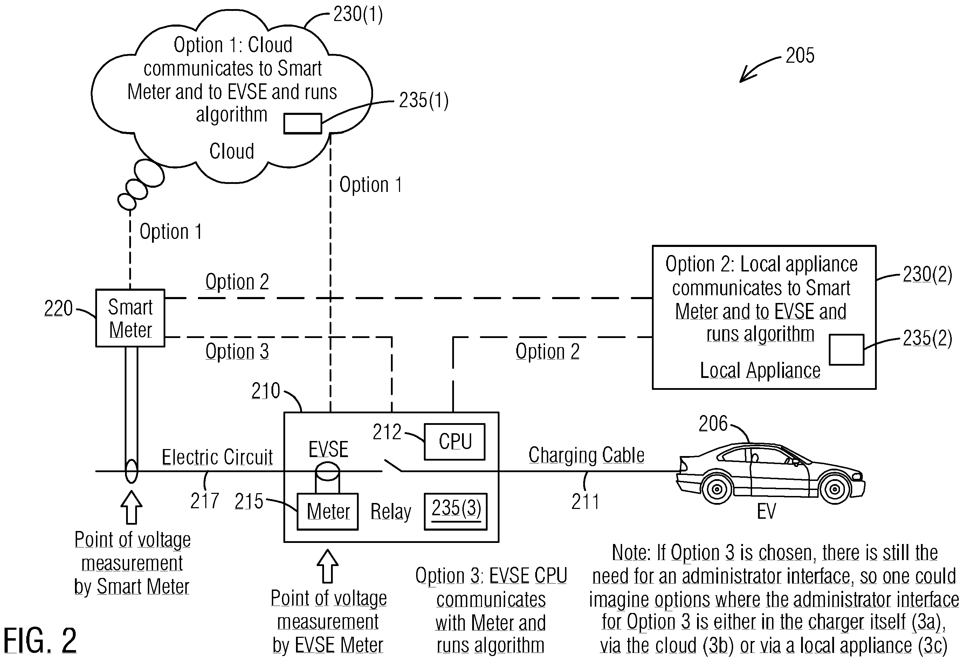

Referring to FIG. 2, it illustrates a detailed predictor 205 of a quality of an electrical installation of electrical vehicle (EV) charging infrastructure in accordance with an embodiment of the present invention. An EV 206 is connected to an electric vehicle supply equipment (EVSE) 210 via a charging cable 211. The EVSE 210 includes a central processing unit (CPU) 212 and a meter 215. The EVSE 210 is connected to an electric circuit 217. A smart meter 220 is connected to the electric circuit 217.

The EVSE 210 includes communications and central processing unit (CPU) and a safety micro controller unit (MCU). The EVSE 210 further includes a first Ethernet interface(I/F), a first Wi-Fi interface(I/F), a RS485 I/F and a dry contact input.

In a first variant of the central monitoring software 120, a cloud 230(1) communicates to the smart meter 220 and to a smart EV charger such as the EVSE 210 and runs a first algorithm 235(1). In a second variant of the central monitoring software 120, a local appliance 230(2) communicates to the smart meter 220 and to the smart EV charger such as the EVSE 210 and runs a second algorithm 235(2). In a third variant of the central monitoring software 120, the CPU 212 of the smart EV charger such as the EVSE 210 communicates with the smart meter 220 and runs a third algorithm 235(3).

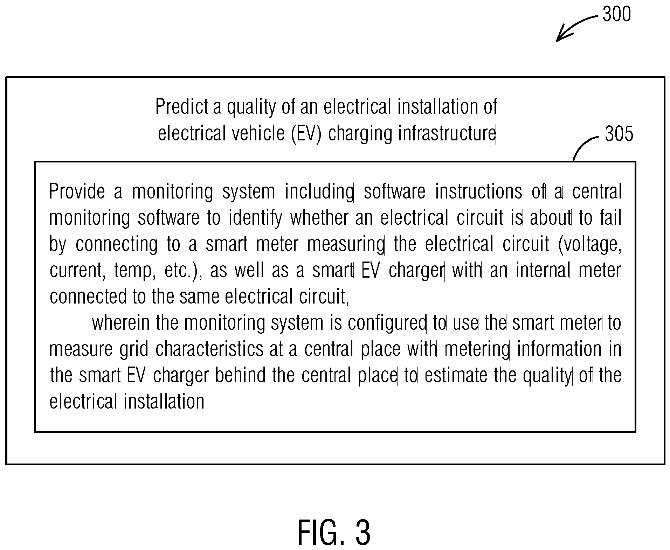

Turning now to FIG. 3, it illustrates a method 300 of predicting a quality of an electrical installation of electrical vehicle (EV) charging infrastructure in accordance with an embodiment of the present invention. Reference is made to the elements and features described in FIGs. 1-2. It should be appreciated that some steps are not required to be performed in any particular order, and that some steps are optional.

The method 300 comprises a step 305 of providing the monitoring system 115 including software instructions of the central monitoring software 120 to identify whether an electrical circuit is about to fail by connecting to a smart meter measuring the electrical circuit (voltage, current, temp, etc.), as well as a smart EV charger with an internal meter connected to the same electrical circuit. The monitoring system 115 is configured to use the smart meter to measure grid characteristics at a central place with metering information in the smart EV charger behind the central place to estimate the quality of the electrical installation.

While a voltage meter is described here a range of one or more other meters are also contemplated by the present invention. For example, other meters may be implemented based on one or more features presented above without deviating from the spirit of the present invention.

The techniques described herein can be particularly useful for a monitoring system that uses a smart meter that measures grid characteristics at a central place with metering information in each EV charger behind this central place to estimate quality of electrical installation. While particular embodiments are described in terms of these metrics, the techniques described herein are not limited to such a system but can also be used with other types of systems.

While embodiments of the present invention have been disclosed in exemplary forms, it will be apparent to those skilled in the art that many modifications, additions, and deletions can be made therein without departing from the spirit and scope of the invention and its equivalents, as set forth in the following claims.

Embodiments and the various features and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure embodiments in detail. It should be understood, however, that the detailed description and the specific examples, while indicating preferred embodiments, are given by way of illustration only and not by way of limitation. Various substitutions, modifications, additions and/or rearrangements within the spirit and/or scope of the underlying inventive concept will become apparent to those skilled in the art from this disclosure.

As used herein, the terms "comprises," "comprising," "includes," "including," "has," "having" or any other variation thereof, are intended to cover a non-exclusive inclusion. For example, a process, article, or apparatus that comprises a list of elements is not necessarily limited to only those elements but may include other elements not expressly listed or inherent to such process, article, or apparatus.

Additionally, any examples or illustrations given herein are not to be regarded in any way as restrictions on, limits to, or express definitions of, any term or terms with which they are utilized. Instead, these examples or illustrations are to be regarded as being described with respect to one particular embodiment and as illustrative only. Those of ordinary skill in the art will appreciate that any term or terms with which these examples or illustrations are utilized will encompass other embodiments which may or may not be given therewith or elsewhere in the specification and all such embodiments are intended to be included within the scope of that term or terms.

In the foregoing specification, the invention has been described with reference to specific embodiments. However, one of ordinary skill in the art appreciates that various modifications and changes can be made without departing from the scope of the invention. Accordingly, the specification and figures are to be regarded in an illustrative rather than a restrictive sense, and all such modifications are intended to be included within the scope of invention.

Although the invention has been described with respect to specific embodiments thereof, these embodiments are merely illustrative, and not restrictive of the invention. The description herein of illustrated embodiments of the invention is not intended to be exhaustive or to limit the invention to the precise forms disclosed herein (and in particular, the inclusion of any particular embodiment, feature or function is not intended to limit the scope of the invention to such embodiment, feature or function). Rather, the description is intended to describe illustrative embodiments, features and functions in order to provide a person of ordinary skill in the art context to understand the invention without limiting the invention to any particularly described embodiment, feature or function. While specific embodiments of, and examples for, the invention are described herein for illustrative purposes only, various equivalent modifications are possible within the spirit and scope of the invention, as those skilled in the relevant art will recognize and appreciate. As indicated, these modifications may be made to the invention in light of the foregoing description of illustrated embodiments of the invention and are to be included within the spirit and scope of the invention. Thus, while the invention has been described herein with reference to particular embodiments thereof, a latitude of modification, various changes and substitutions are intended in the foregoing disclosures, and it will be appreciated that in some instances some features of embodiments of the invention will be employed without a corresponding use of other features without departing from the scope and spirit of the invention as set forth. Therefore, many modifications may be made to adapt a particular situation or material to the essential scope and spirit of the invention.

Respective appearances of the phrases "in one embodiment," "in an embodiment," or "in a specific embodiment" or similar terminology in various places throughout this specification are not necessarily referring to the same embodiment. Furthermore, the particular features, structures, or characteristics of any particular embodiment may be combined in any suitable manner with one or more other embodiments. It is to be understood that other variations and modifications of the embodiments described and illustrated herein are possible in light of the teachings herein and are to be considered as part of the spirit and scope of the invention.

In the description herein, numerous specific details are provided, such as examples of components and/or methods, to provide a thorough understanding of embodiments of the invention. One skilled in the relevant art will recognize, however, that an embodiment may be able to be practiced without one or more of the specific details, or with other apparatus, systems, assemblies, methods, components, materials, parts, and/or the like. In other instances, well-known structures, components, systems, materials, or operations are not specifically shown or described in detail to avoid obscuring aspects of embodiments of the invention. While the invention may be illustrated by using a particular embodiment, this is not and does not limit the invention to any particular embodiment and a person of ordinary skill in the art will recognize that additional embodiments are readily understandable and are a part of this invention.

It will also be appreciated that one or more of the elements depicted in the drawings/figures can also be implemented in a more separated or integrated manner, or even removed or rendered as inoperable in certain cases, as is useful in accordance with a particular application.

Benefits, other advantages, and solutions to problems have been described above with regard to specific embodiments. However, the benefits, advantages, solutions to problems, and any component(s) that may cause any benefit, advantage, or solution to occur or become more pronounced are not to be construed as a critical, required, or essential feature or component.

### Further Embodiments

1. A predictor of a quality of an electrical installation of electrical vehicle (EV) charging infrastructure, the predictor comprising:
   a monitoring system including software instructions of a central monitoring software to identify whether an electrical circuit is about to fail by connecting to one or several smart meters (primary and/or secondary meters) measuring the electrical circuit (voltage, current, temp, etc.), as well as a smart EV charger with an internal meter connected to the same electrical circuit, and
   wherein the monitoring system is configured to use the smart meter to measure grid characteristics at a central place with metering information in the smart EV charger behind the central place to estimate the quality of the electrical installation.
2. The predictor of embodiment 1, wherein whenever the smart EV charger is charging, the monitoring system will compare a voltage between the smart meter and the smart EV charger.
3. The predictor of embodiment 2, wherein predicting a failure by the monitoring system is going to happen based on a deteriorated resistance in the electrical circuit.
4. The predictor of embodiment 3, wherein the electrical circuit that presents a higher resistance than expected can cause overheating and damage.
5. The predictor of embodiment 1, wherein the smart meter is a voltage meter and the internal meter of the smart EV charger is a voltage meter.
6. The predictor of embodiment 1, wherein the smart meter is a meter behind the internal meter of the smart EV charger.
7. The predictor of embodiment 1, wherein a current flowing through the smart EV charger is known, and therefore a resistance of the electrical circuit between the smart meter and the smart EV charger can be calculated as R = (Vsmart meter - Vev charger)/I such that the resistance can be calculated at different current levels, and at different external ambient temperatures (measured at the smart EV charger), as well different charging session durations.
8. The predictor of embodiment 1, wherein in a first variant of the central monitoring software a cloud communicates to the smart meter and to the smart EV charger such as an EVSE and runs an algorithm.
9. The predictor of embodiment 1, wherein in a second variant of the central monitoring software a local appliance communicates to the smart meter and to the smart EV charger such as an EVSE and runs an algorithm.
10. The predictor of embodiment 1, wherein in a third variant of the central monitoring software a CPU of the smart EV charger such as an EVSE communicates with the smart meter and runs an algorithm.
11. A method of predicting a quality of an electrical installation of electrical vehicle (EV) charging infrastructure, the method comprising:
   providing a monitoring system including software instructions of a central monitoring software to identify whether an electrical circuit is about to fail by connecting to one or several smart meters (primary and/or secondary meters) measuring the electrical circuit (voltage, current, temp, etc.), as well as a smart EV charger with an internal meter connected to the same electrical circuit, and
   wherein the monitoring system is configured to use the smart meter to measure grid characteristics at a central place with metering information in the smart EV charger behind the central place to estimate the quality of the electrical installation.
12. The method of embodiment 11, wherein whenever the smart EV charger is charging, the monitoring system will compare a voltage between the smart meter and the smart EV charger.
13. The method of embodiment 12, wherein predicting a failure by the monitoring system is going to happen based on a deteriorated resistance in the electrical circuit.
14. The method of embodiment 13, wherein the electrical circuit that presents a higher resistance than expected can cause overheating and damage.
15. The method of embodiment 11, wherein the smart meter is a voltage meter and the internal meter of the smart EV charger is a voltage meter.
16. The method of embodiment 11, wherein the smart meter is a meter behind the internal meter of the smart EV charger.
17. The method of embodiment 11, wherein a current flowing through the smart EV charger is known, and therefore a resistance of the electrical circuit between the smart meter and the smart EV charger can be calculated as R = (Vsmart meter - Vev charger)/I such that the resistance can be calculated at different current levels, and at different external ambient temperatures (measured at the smart EV charger), as well different charging session durations.
18. The method of embodiment 11, wherein in a first variant of the central monitoring software a cloud communicates to the smart meter and to the smart EV charger such as an EVSE and runs an algorithm.
19. The method of embodiment 11, wherein in a second variant of the central monitoring software a local appliance communicates to the smart meter and to the smart EV charger such as an EVSE and runs an algorithm.
20. The method of embodiment 11, wherein in a third variant of the central monitoring software a CPU of the smart EV charger such as an EVSE communicates with the smart meter and runs an algorithm.

## Claims

1. A predictor of a quality of an electrical installation of electrical vehicle (EV) charging infrastructure, the predictor comprising:
a monitoring system including software instructions of a central monitoring software to identify whether an electrical circuit is about to fail by connecting to one or several smart meters (primary and/or secondary meters) measuring the electrical circuit (voltage, current, temp, etc.), as well as a smart EV charger with an internal meter connected to the same electrical circuit, wherein the monitoring system is configured to use the smart meter to measure grid characteristics at a central place with metering information in the smart EV charger behind the central place to estimate the quality of the electrical installation.

2. The predictor of claim 1, wherein whenever the smart EV charger is charging, the monitoring system will compare a voltage between the smart meter and the smart EV charger.

3. The predictor according to any of the preceding claims, wherein predicting a failure by the monitoring system is going to happen based on a deteriorated resistance in the electrical circuit.

4. The predictor according to any of the preceding claims, wherein the electrical circuit that presents a higher resistance than expected can cause overheating and damage.

5. The predictor according to any of the preceding claims, wherein the smart meter is a voltage meter and the internal meter of the smart EV charger is a voltage meter.

6. The predictor according to any of the preceding claims, wherein the smart meter is a meter behind the internal meter of the smart EV charger.

7. The predictor according to any of the preceding claims, wherein a current flowing through the smart EV charger is known, and therefore a resistance of the electrical circuit between the smart meter and the smart EV charger can be calculated as R = (Vsmart meter - Vev charger)/I such that the resistance can be calculated at different current levels, and at different external ambient temperatures (measured at the smart EV charger), as well different charging session durations.

8. The predictor according to any of the preceding claims, wherein:
in a first variant of the central monitoring software a cloud communicates to the smart meter and to the smart EV charger such as an EVSE and runs an algorithm; and/or
in a second variant of the central monitoring software a local appliance communicates to the smart meter and to the smart EV charger such as an EVSE and runs an algorithm; and/or
in a third variant of the central monitoring software a CPU of the smart EV charger such as an EVSE communicates with the smart meter and runs an algorithm.

9. A method of predicting a quality of an electrical installation of electrical vehicle (EV) charging infrastructure, the method comprising:
providing a monitoring system including software instructions of a central monitoring software to identify whether an electrical circuit is about to fail by connecting to one or several smart meters (primary and/or secondary meters) measuring the electrical circuit (voltage, current, temp, etc.), as well as a smart EV charger with an internal meter connected to the same electrical circuit, and
wherein the monitoring system is configured to use the smart meter to measure grid characteristics at a central place with metering information in the smart EV charger behind the central place to estimate the quality of the electrical installation.

10. The method of claim 9, wherein whenever the smart EV charger is charging, the monitoring system will compare a voltage between the smart meter and the smart EV charger.

11. The method according to any of the preceding method-based claims, wherein predicting a failure by the monitoring system is going to happen based on a deteriorated resistance in the electrical circuit.

12. The method according to any of the preceding method-based claims, wherein the electrical circuit that presents a higher resistance than expected can cause overheating and damage.

13. The method according to any of the preceding method-based claims, wherein the smart meter is a voltage meter and the internal meter of the smart EV charger is a voltage meter and/or wherein the smart meter is a meter behind the internal meter of the smart EV charger.

14. The method according to any of the preceding method-based claims, wherein a current flowing through the smart EV charger is known, and therefore a resistance of the electrical circuit between the smart meter and the smart EV charger can be calculated as R = (Vsmart meter - Vev charger)/I such that the resistance can be calculated at different current levels, and at different external ambient temperatures (measured at the smart EV charger), as well different charging session durations.

15. The method according to any of the method-based preceding claims, wherein:
in a first variant of the central monitoring software a cloud communicates to the smart meter and to the smart EV charger such as an EVSE and runs an algorithm; and/or
in a second variant of the central monitoring software a local appliance communicates to the smart meter and to the smart EV charger such as an EVSE and runs an algorithm; and/or
in a third variant of the central monitoring software a CPU of the smart EV charger such as an EVSE communicates with the smart meter and runs an algorithm.
